# EUROPEAN PATENT APPLICATION

(11) **EP 1 067 602 A1**
(43) Date of publication of application: **10.01.2001**
(21) Application number: 99830437.2
(22) Date of filing: 07.07.1999
(51) Int. Cl.: H01L 23/495, H01L 21/66

(54) **Un-packaged or semi-packaged electrically tested electronic semiconductor device free from infantile mortality and process for manufacture thereof**

(71) Applicant: EEMS Italia S.p.a., 02015 Cittaducale (RI) (IT)
(72) Inventor: Betori, Francesco, Cittaducale (RI) (IT)
(74) Representative: Taliercio, Antonio

(57) **Abstract**

An un-packaged or semi-packaged, electrically tested electronic device, free from infantile mortality, characterized in that it comprises a silicon platelet or die (11) having a top surface and a bottom surface, in which an integrated circuit is realized externally accessible through a plurality of connection pads and an array of connection pins (10; 13; 14) which are mechanically and removably connected to said silicon die (11) by connection means and are electrically connected to the connection pads of said silicon die (11) by electric connection means (12).

## Description

This invention broadly relates to manufacture of semiconductor electronic devices and more particularly concerns the realization of electronic devices in the form of silicon dies, namely un-packaged or semi-packaged devices, adapted to be directly mounted on supports or leadframes of various kinds, such devices being electrically tested and free of the so-called infantile mortality.

Before setting forth a detailed description of the prior art and of the problems this invention intends to solve, it is believed convenient to give some indications of the terminology commonly adopted in this field.

Under the term of electronic component, it is generally meant the assembly of an incapsulation or package and of a die or chip which represents the electronic device in the form of a "silicon platelet".

In the technology of the integrated semiconductor devices, the die represents the material unit or individual substrate on which all of the elements (active, passive, etc.) are manufactured. The concerned die is obtained after the technologic manufacturing process has been carried out on the silicon slice or disc (wafer) and represents a small fraction of it.

The wafer is obtained by means of a complex set of working steps that can be summarized as follows: oxidation; passivation; metal deposition; masking and etching of the layers; doping; etc.. The sequence of the manufacturing steps and the use of different materials are determined by the typologic parameters of the devices to be manufactured.

In view of its very small dimensions, the manufactured die is incapsulated in suitable casings or packages, provided with easily accessible connection terminals, designated as feet or pins. Such packages are made in plastic material, of thermosetting or thermoplastic type, in ceramics, in metal or composite materials. A single package can contain a single die, or multiple dies; in the latter use, they are also called Multiple-Chip-Modules (M.C.M.).

Under the term of support or strip, a mounting structure for the die is to be meant which can be:
a) a strip of metal plate or plastic material containing the connection (internal/external) pins on which the die is to be mounted;
b) a strip of ceramic, metal or plastic material or a printed circuit board on which both the die mounting pads and the connection tracks are realized by means of various techniques.

The concerned die is subsequently connected to the pads by means of various techniques:
- micrometric wires;
- metallized resilient connections;
- micrometric balls grown on the die.

The support, that can also include some auxiliary devices needed for its operation, such as resistors, capacitors, bridges and like, can be realized according to pre-established shapes, responding to various standard formats, or shapes determined by the free spaces available in the product in which it is used.

Under the term of burn-in, an accelerated ageing operation of the products is to be meant, which is carried out in stressed temperature conditions, by utilizing electric signals adapted to speed-up the defect appearance time. This operation allows to immediately discard all those products in which the failures would appear within a short time period, thereby eliminating the so-called infantile mortality of the electronic devices. In this way, it is possible to guarantee that the electronic components which overcome this test can operate in the best conditions for a certain number of operation years and only beyond such limit the concerned components are subject to natural ageing.

As above mentioned, the silicon platelets containing the electronic devices are usually incapsulated in casings or packages, of plastic or ceramic material, in order to be protected and to allow an easier connection thereof through their pins. The package, therefore, provides the devices with a number of capabilities, in particular, it makes manipulation thereof easier; furthermore it guarantees their mechanical strength in addition to providing protection against the external degenerative agents (such as humidity, saline atmospheres and like) during their operation and includes all necessary pins to assure their electric connection both to the external world and to the die, with associated possible welding spots.

There are a number of applications, however, in which, due to space restriction reasons or due to manufacturing reasons, it is necessary that the dies be directly mounted on the printed circuit boards (pcb) or on said ceramic supports, without being incapsulated within the above described packages.

Since the individual dies are not normally guaranteed as free from infantile mortality problems, the need of special dies, so called KGD (Known Good Die), that should be sorted, tested and free from infantile mortality, is being increasingly felt. These special components are manufactured by means of various processes, with continuous efforts to overcome the hard difficulties connected with their manipulation and with the electric contacts, in the first place due to the small dimensions of such components as well as of their auxiliary devices, as it is well known to those skilled in the art.

Due to the large and increasing demand of KGD devices, several manufacturing technologies have been developed for electric testing and artificial ageing of such devices. The most popular solutions are as follows: i) utilization of flexible contacts on the wafer; ii) application of removable contacts (by means of connections to provisional structures by means of micrometric wires or by application of small gold balls); iii) utilization of special sockets, for instance needle sockets.

As concerns the first approach, specially designed membranes are utilized that, through the micrometric electric contacts of the pads, enable the bum-in and the electric test of the dies to be carried out. As concerns the second approach, the dies are connected by means of micrometric electric wires to external contact points, through which it is possible to easily carry out the ageing and testing operations. Subsequently, the wires and the related welding spots are softly removed so that the components appear again in their original condition. This operation, when it is not carried out in correct way, causes damages to the pads with negative consequences to the reliability of the resulting device. The third approach utilizes special, also temperature resistant sockets, which contain micrometric electric contacts, for instance flexible needle shaped contacts, by means of which it is possible to contact the pads in order to perform the electric test and the burn-in operations.

The present flow chart for manufacturing un-packaged individual devices of the KGD type includes the following steps:
1a) - contacting the pads through special flexible membranes on the wafer, or
1b) - cutting, separating and identifying the dies,
1c) - catching the dies and depositing them in special sockets, or
1d) - mounting and provisionally connecting the dies,
2) - electrically testing;
3) - burning-in
4) - finally electrically testing,
5) - removing the provisional connections (in respect of step 1d)), or
6) - cutting, separating, identifying and taking up (in respect of step 1a)),
7) - packaging.

In view of the high number of dies per wafer (in the order of hundreds / wafer) and of contact spots (in the order of tens / die) and due to the need to guarantee and assure their contemporaneous electric contact during a pre-established time span, the technology based upon use of flexible membranes does not assure effective test and bum-in operations and this results in manufacturing unreliable products.

The manufacturing technique based upon provisional connection of the dies, on the other hand, due to the subsequent critical operation aimed at removing the connection, can cause severe damages to the pads, with resulting reliability problems in the dies as a function of the time.

The adoption of sockets specially designed for micrometric pads aimed at contacting the dies turns out to be extremely expensive both due to the high cost of the sockets themselves and due to the difficulties to be faced in contacting/centering the dies, also in view of the dimensions of the dies and of the pads.

Having all above mentioned circumstances in mind, the manufacturers of special applications, such as MCM/DCA (Multiple Chip Modulo/Direct Chip Assembly) are obliged to restrict the utilization field of the final products, to manufacture low level applications, to significantly increase the re-working operations in order to eliminate the fault affected devices and, lastly, to increase the number of dies to be mounted, so as to utilize some of them as spare items.

It is an object of this invention to eliminate or at least substantially mitigate the above outlined drawbacks and disadvantages and to propose a solution the essential idea of which is to realize a dummy structure to be added to the die in order to enable both the singularized dies to be manipulated and the internal contact spots to be accessed, so as to carry out the testing/accelerated ageing operations, without significantly modifying the utilizability of the die with respect to its original structure.

The device according to this invention, therefore, belongs to the KGD class and it can be specifically designated as L.D.P., namely Leaded Die Package: it is comprised of the die which is mounted by means of double side adhesive tapes or glues (for instance epoxide/polyamide glues) on metal pins (dummy structure) and connected to them by means of micrometric gold wires, according to connection patterns defined in compliance with the kind of the device it is desired to realize and with the kind of die to be utilized therein.

The dummy or pseudo-structure according to this invention, also in its un-packaged embodiment, modifies the manipulation possibilities for the die so that it behaves just as if it were packaged in a conventional package and, therefore, it allows to obtain:
- an easier electric contact, as it is needed to carry out the electric testing and burn-in operations,
- a suitable mechanical strength in order to be manipulated during all manufacturing steps, without running any risk to damage it,
- a subsequent mechanic/electric contact on the plates/supports, for instance by means of tin soldering.

The dummy structure according to this invention can be realized in various embodiments, in order to meet the requirements of all manufacturing typologies of the dies, in particular:
- dies having connection pads arranged only in central lines,
- dies having peripheral connection pads arranged along two or all four side edges and, therefore, spaced from the central point of the dies,
- mixed dies, namely dies having a combination of the patterns described in the previous sections.

Further details, particulars and advantages of this invention will be evident from the following description with reference to enclosed drawings wherein the preferred embodiments are shown by way of illustration and not by way of limitation.

In the drawings:
Figure 1 is a perspective view of a device according to this invention showing an embodiment in which the connection pads are arranged at the peripheral edges,
Figure 2 is a perspective view of a device according to this invention showing an embodiment in which the connection pads are arranged along central lines,
Figure 3 shows a further provided with centrally arranged connection pads similar to the one shown in Figure 2 but having pre-formed pins,
Figure 4 shows a further device provided with centrally arranged connection pads similar to the one shown in Figure 2, but having the pins realized by metallization on a substrate of plastic material,
Figure 5 is a cross-section view of a device provided with centrally arranged connection pads as in Figure 2 or in Figure 4,
Figure 6 is a perspective view of a device provided with centrally arranged connection pads, the die being mounted upon the support, before cutting away the pins from the latter, so as to obtain, for instance, the device shown in Figure 2,
Figures 7A and 7B are cross-section views showing two embodiments of the semi-packaging step of a die housed in a mold, by casting or injecting a resin therein,
Figure 8 is a top plan view of a die with a central array of connection pads, pin arrays arranged on four side edges and two conductive bars,
Figure 9 and 10 cross-section views taken along the longitudinal and transversal extensions of the bar according to corresponding arrows,

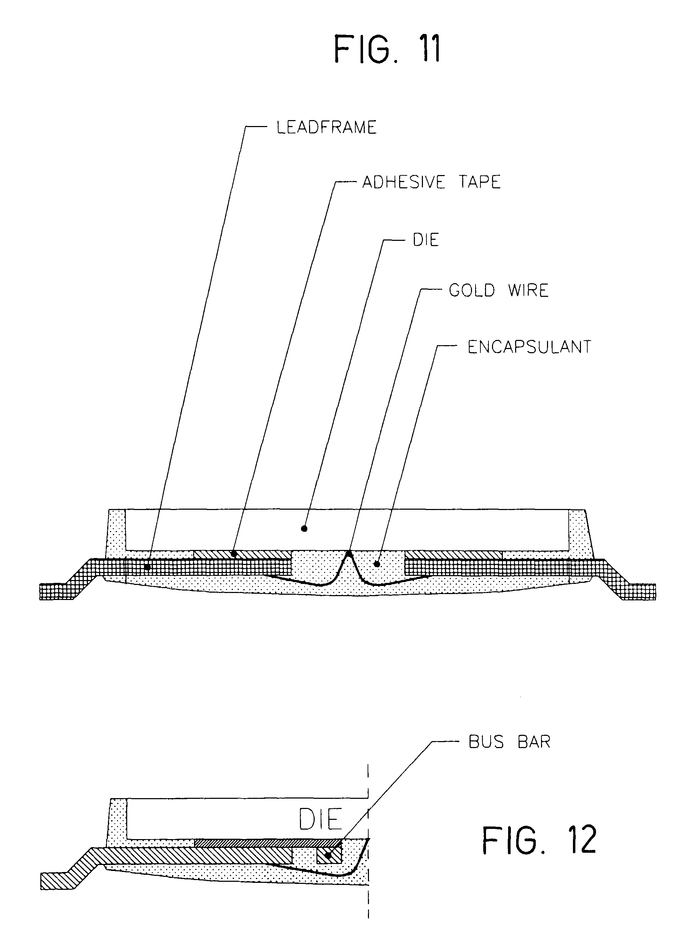

Figure 11 shows a semi-packaged die according to this invention with pre-formed pins, ready for use,
Figure 12 is a fragmentary view similar to Figure 11 in respect of a die provided with conductive bar.

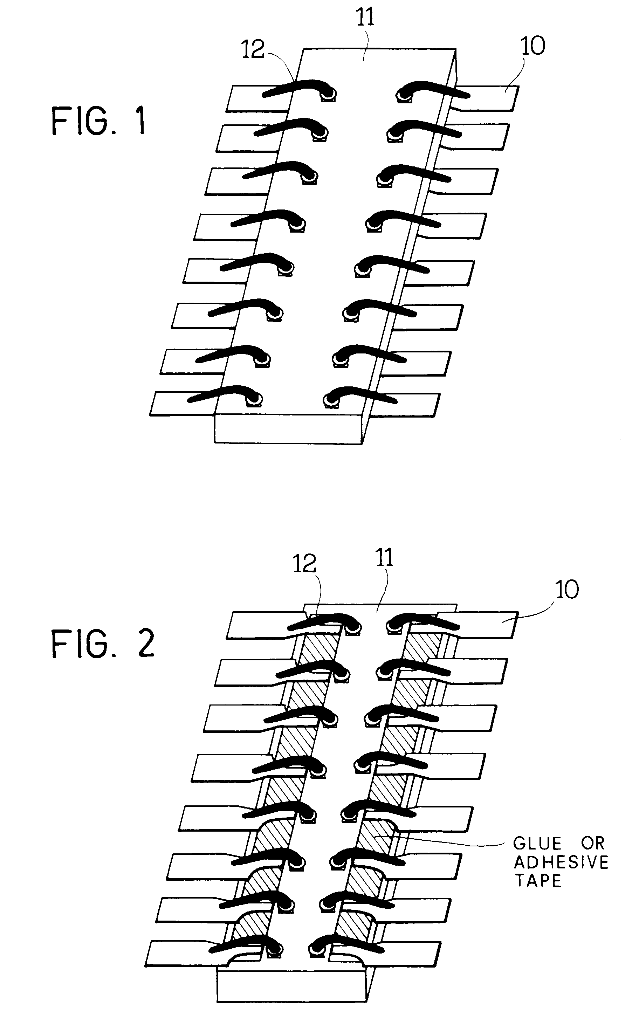

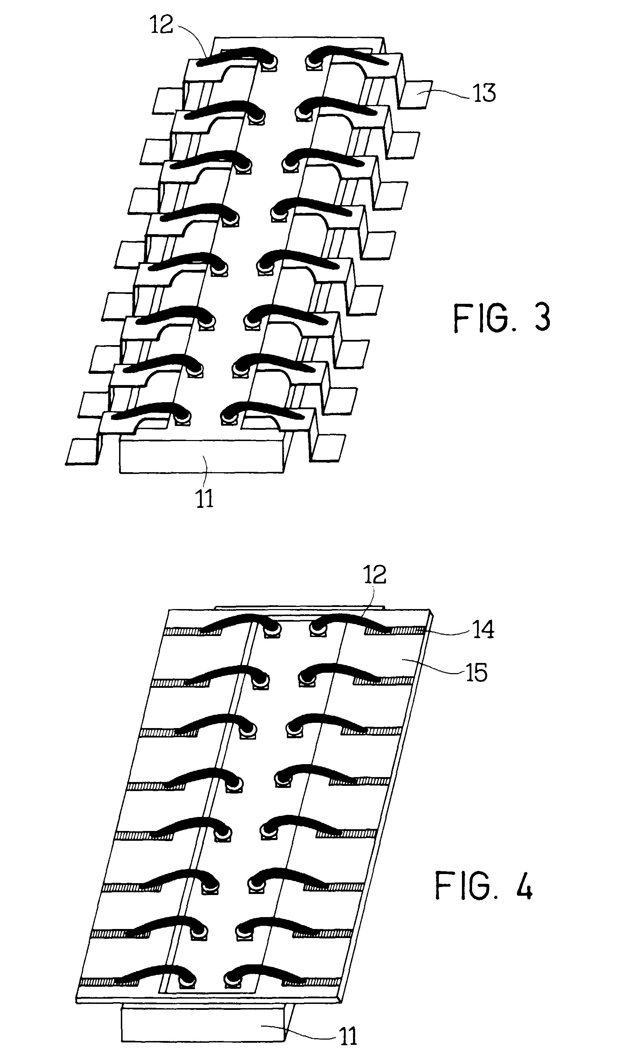

By referring now broadly to the drawings, it can be observed that the dummy structure according to this invention comprises a set of feet or pins that can be made of metal, as they are in Figures 1, 2, 3 or 6, or can be made by deposition of metal tracks upon a substrate of plastic material, such as kapton® , as in Figure 4. The pins are attached to the top surface of the die when a device with centrally aligned connection pads is involved or they can be affixed to the bottom surface of the die, when a device provided with peripheral connection pads is involved.

Furthermore, the pins can be coated by chemical or galvanic process with alloys or metals adapted to make a subsequent soldering step easier, such as tin/lead alloys, palladium, gold and like and they can also protrude from the concerned die in order to enable it to be mounted on a printed circuit board (pcb).

By specifically referring to Figure 1, a structure according to this invention can be observed in respect of an embodiment in which the connection pads are peripherally arranged, with the above mentioned pins 10 affixed to the bottom surface of a die 11 and readily accessible by the connection or bonding wires 12.

By referring to Figure 2, a device is shown having the connection pads arranged along central lines and provided with pins 10 affixed to the top surface of the die 11. In this Figure, the system adopted to affix the pins by means of a double-side adhesive tape or a suitable glue can be observed.

A device of the kind illustrated in Figure 3 strictly corresponds to the one illustrated in Figure 2, but it is provided with a distinctive feature that the pins 13 are pre-formed in order to promote or help assembling the concerned component on the printed circuit board as well as to accommodate the elongation differences due to thermal expansion of the materials of which the pins, the die and the printed circuit board are made.

By referring to Figure 4, an embodiment of a device provided with central connection pads can be observed, in which the pins 14 are realized as metallized tracks on the board of plastic material 15, which is affixed to the die 11 by means of a suitable double-side adhesive tape or a glue. The interconnections between the connection pads of the die and the metallized pins 14 are realized by means of conventional welded bonding wires 12.

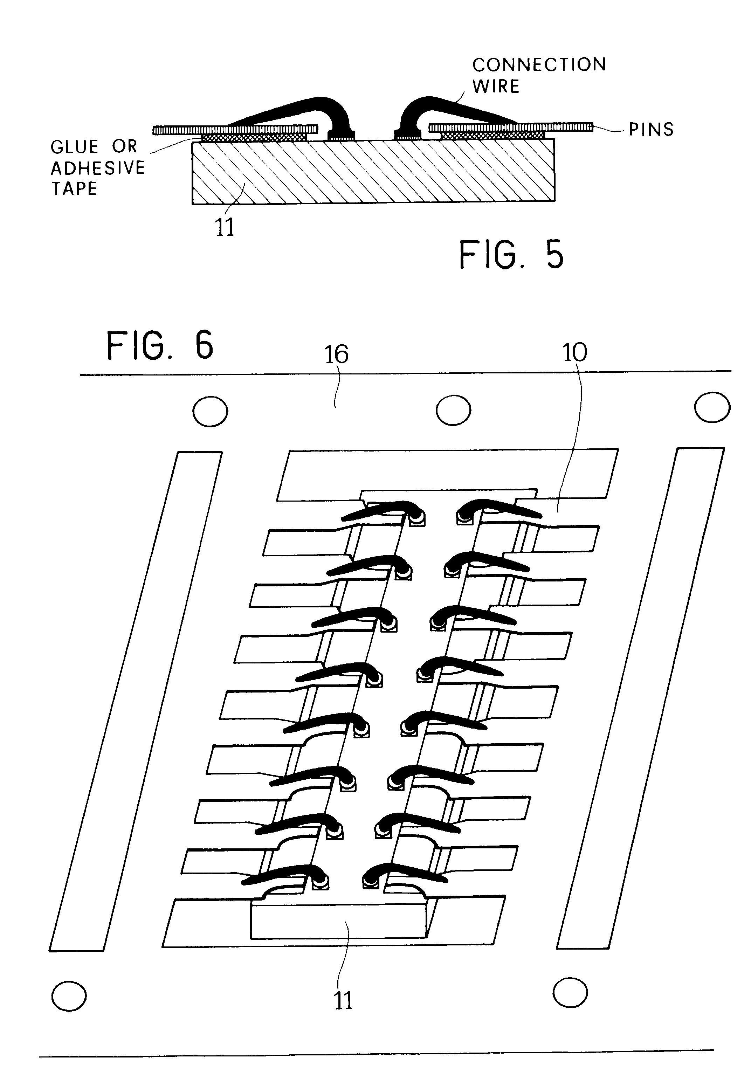

Figure 5 illustrates an elevation cross-section view of a device according to this invention of the kind illustrated in Figure 2 or in Figure 4.

Figure 6 shows a perspective view of a die 11 assembled according to the construction of Figure 2 at a stage of the manufacturing process at which the cutting operation of the pins 10 from the metal support tape or strip 16 has not been carried out as yet.

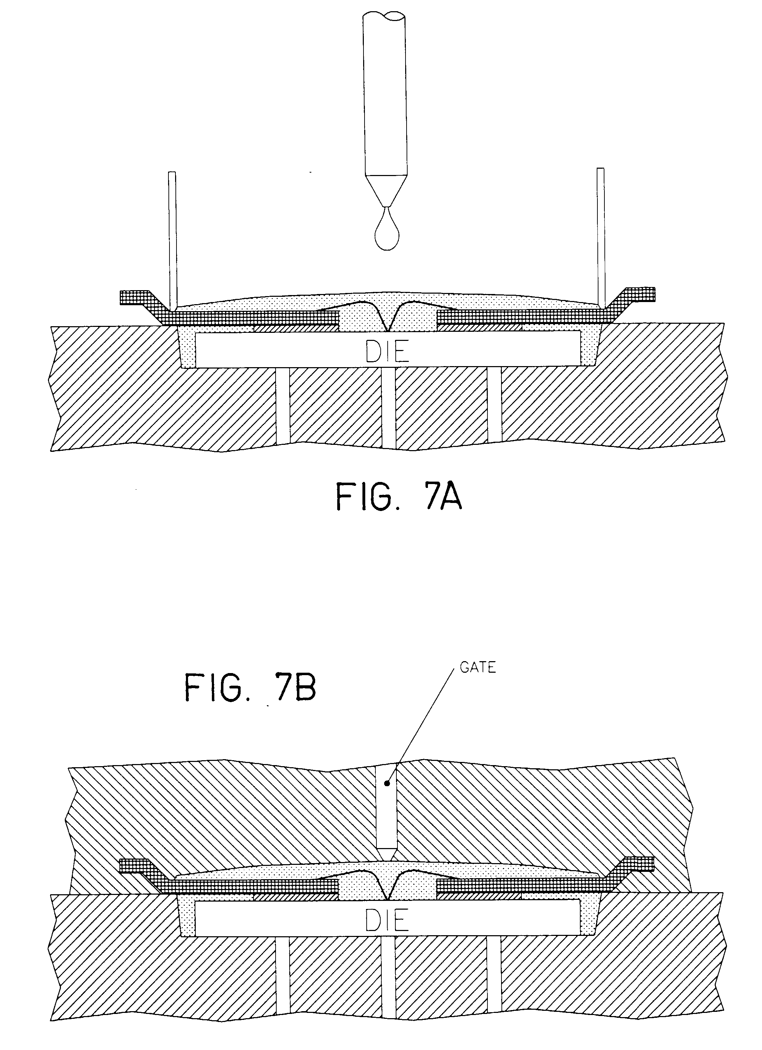

By referring to Figures 7A and 7B, a step is shown in which the die under process is semi-packaged, in the sense that it is mounted in a semi-package that covers it only partially, so as to protect the bonding wires as well as the flanks of the die and to expose its major bottom surface (as it appears in the Figures), in order to also make the removal of the heat therefrom easier.

In this operation, the die is housed in a suitable mold with its surface to be left exposed downwardly oriented and it is subsequently covered by injected or cast liquid resin.

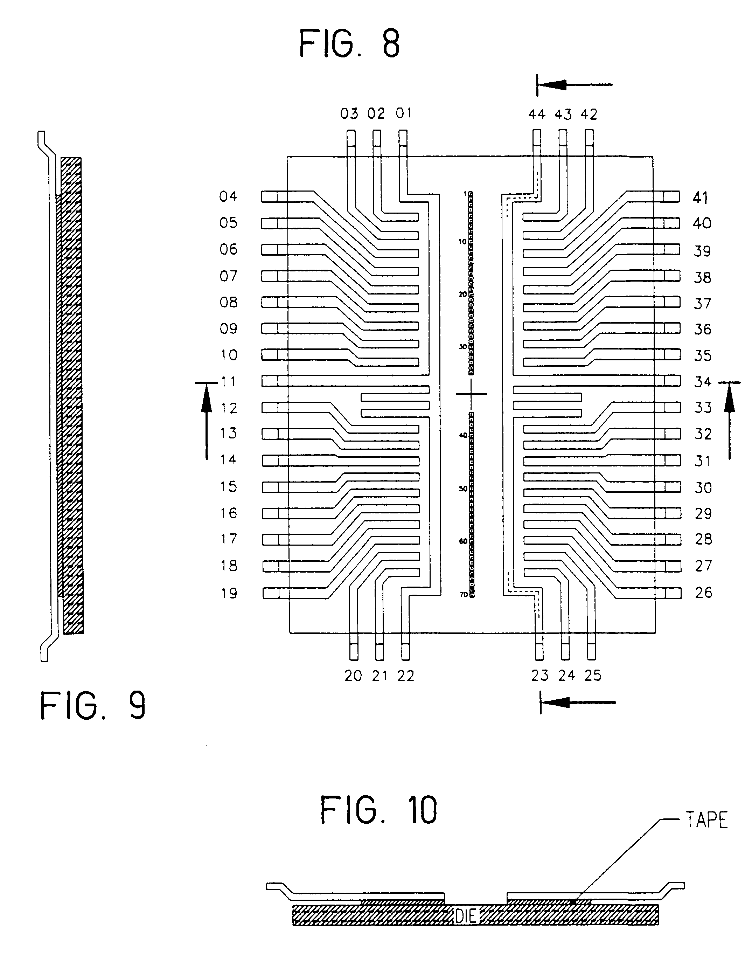

By referring to Figures 8, 9 and 10, a chip is shown according to the preferred embodiment of this invention, of the type having the array of the connection pads arranged along an aligned central longitudinal row. It is characterized, in the first place, in that the pins intended for external connections are arranged according to a suitable distribution on all four side edges of the chip and not only two major side edges, as in the prior art. In the second place, the presence is to be remarked of conductive bars corresponding to pins 1,11 and 22 , on one side, and 23, 34 and 44, on the other side. Such conductive bars having three or more contact points allow the ground potential and/or the power supply to be coupled to various points of the chip, thereby achieving a resulting up-grading of the electrical performances of the device.

The assembly of these features appears to be particularly advantageous in devices of some kinds, namely: in all those devices in which heat is generated, since the suggestion according to this invention promotes the removal of any heat generated therein. The suggestion is also advantageous in all devices presently having large dimensions, because they can be made smaller, due to elimination of some ground pins, as it is made possible by adoption of said ground bars; lastly, all those devices that, due to the significant length of the contact paths, are subject to degradation of their electrical performances, particularly at high operation speed.

A further characteristic of this invention is to be identified in that the leadframe, considered as the assembly of the connection pins, is of the so-called pre-bent or pre-formed type and this pre-formation is of small amount and, therefore, it can be directly and economically realized by the manufacturer of the leadframes, thereby leaving to the assembler of the chips the only burden to cut the pins of the leadframes to size and to realize semi-packaging of the dies, if desired. This feature is particularly distinctive of the chips according to this invention with respect to the chips of the prior art in which the pins of the leadframe are completely bent around the package, which needs to be done by means of a critic and expensive bending operation to be carried out by the same chip assembler and not by the leadframe manufacturer.

In this respect, reference is made to the paper "CSP with LOC Technology", The International Journal of Microcircuits and Electronic Packaging, Vol. 20, No. 2, Second Quarter 1997, disclosing a chip which is completely packaged and having pins completely bent around it.

In view of all above said, it can be understood that the flow chart of a typical manufacturing process for producing the structures according to this invention, in the un-packaged embodiment, includes the following steps:
a) cutting the dies,
b) mounting the dies according to requested electronic or physical map upon the metal multiple pattern support, by means of glues or double side adhesive tapes,
c) connecting the connection pads of the die to the metal support according to the desired pre-established outlines, by means of soldered micrometric wires,
d) cutting and separating the metal support,
e) electrically testing,
f) insertion into the burn-in sockets,
g) burning-in,
h) finally electrically testing,
i) packing in reels or trays.

As far as the semi-packaged embodiment is concerned, the semi-packaging operation is carried out immediately after connecting the connection pads (step c)) and before cutting and separating the support (step d)) and, if necessary, for instance when said semi-package is realized by a liquid resin, it is followed by a resin curing operation.

It should be understood that, in particular circumstances or applications, also the burn-in operations can be considered as optional, but their omission should not be considered as a departure from the scope of this invention.

In view of all above set forth explanations, a number of advantages ought to be apparent with respect to the prior art.

Summarizing, it can be stated that, particularly in respect of un-packaged dies, components electrically controlled and free from infantile mortality effects are made available for utilization in direct assembly on ceramic supports, printed circuit boards (pcb) and like, without the need to utilize special expensive machinery, with further possibility to preliminarily connect them to supports to be subsequently removed or to encapsulate them in plastic containment casings.

In MCM or DCA applications, this invention enables the need to rework the final product, in order to separate any no more operative components after the test and burn-in operations on the printed circuit board, to be eliminated.

It is possible also to realize an increase in the overall yield of the product in MCM or DCA applications, in view of the fact that it is no more necessary to mount redundant additional dies on the printed circuit board, in order to substitute good components for any pieces failed or discarded during the electric test or the accelerated ageing procedures.

As it has been above mentioned, the dummy structure according to this invention, as a newly designed approach, provides welding points that are insensitive to the physical dimensions of the die. This result is highly advantageous, in that it eliminates the necessity to modify the design of the supports or of the printed circuit board in order to cope with the dimensional variations of the dies.

The preferred embodiments of this invention have been described and a number of variations have been suggested hereinbefore, but it should expressly be understood that those skilled in the art can make other variations and changes, without so departing from the scope of the following claims.

## Claims

1. An un-packaged or semi-packaged, electrically tested electronic device, free from infantile mortality, characterized in that it comprises a silicon platelet or die (11) having a top surface and a bottom surface, in which an integrated circuit is realized externally accessible through a plurality of connection pads and an array of connection pins (10; 13; 14) which are mechanically and removably connected to said silicon die (11) by connection means and are electrically connected to the connection pads of said silicon die (11) by electric connection means (12).

2. An electronic device according to claim 1, characterized in that said connection pads are arranged at the edges of one side of the silicon die (11) and said connection pins are affixed to the edges of the opposite side of said die (11).

3. An electronic device according to claim 1, characterized in that said connection pads are arranged along a central line on a side of said silicon die (11) and said connection pins (10; 13) are attached to the edges of the same side of the die (11).

4. An electronic device according to claim 2 or 3, characterized in that said connection means for removable attachment of said pins (10; 13) to said silicon die (11) are a double-side adhesive tape or a glue.

5. An electronic device according to claim 4, characterized in that said connection pins (13) are of pre-formed type in order to accommodate the thermal expansion differences between the silicon die (11) and the circuit board on which it is mounted.

6. An electronic device according to claim 1, characterized in that said array of connection pins are realized as metallized strips (14) on a board of plastic material (15) removably attached to said silicon die (11) by means of a double-side adhesive tape or glue.

7. An electronic device according to claim 1, characterized in that said pins are obtained by cutting a continuous strip support (16) on which said silicon dies (11) are mounted.

8. An electronic device according to claim 6 or 7, characterized in that said connection pins are distributed on all four side edges of the die.

9. An electronic device according to claim 8, characterized in that said electric connection means between said connection pins (10; 13; 14) and the connection pads of said silicon die are made by welded micrometric bonding wires (12).

10. An electronic device according to claim 9, characterized in that said semi-package covers the surface of the die where said connection pads are arranged together with their connections to the pins made by said bonding wires (12), as well as all flanks of the die, leaving the opposite surface of the die exposed.

11. An electronic device according to claim 9, characterized in that it includes a three or more point, conductive bar aimed at distributing the electric ground potential or power supply to three or more points of the die.

12. A process for manufacturing electrically tested electronic devices, free from infantile mortality, characterized in that, for manufacturing un-packaged devices, it comprises the following steps:
a) cutting the dies,
b) mounting the dies according to requested electronic or physical map upon the metal multiple pattern support, by means of glues or double side adhesive tapes,
c) connecting the connection pads of the die to the metal support according to the desired pre-established outlines, by means of soldered micrometric wires,
d) cutting and separating the metal support,
e) electrically testing,
f) insertion into the burn-in sockets,
g) burning-in,
h) finally electrically testing,
i) packing in reel or trays.

13. A manufacturing process according to claim 12, characterized in that, as far as the semi-packaged devices are concerned, the semi-packaging operation is carried out with resin immediately after connecting the connection pads (step c)) and before cutting and separating the support (step d)) and, if necessary, it is followed by a resin curing operation.

14. A manufacturing process according to claim 13, characterized in that said semi-packaging is carried out in a mold by utilizing a liquid resin.
